# EUROPEAN PATENT SPECIFICATION

(11) **EP 3 327 724 B1**
(45) Date of publication and mention of the grant of the patent: **28.10.2020**
(21) Application number: 18151106.4
(22) Date of filing: 19.09.2014
(51) Int. Cl.: G11C 17/16, G11C 17/18

(54) **CIRCUIT AND SYSTEM OF USING JUNCTION DIODE AS PROGRAM SELECTOR FOR ONE-TIME PROGRAMMABLE DEVICES**
SCHALTUNG UND SYSTEM ZUR VERWENDUNG EINER FLÄCHENDIODE ALS PROGRAMMWÄHLER FÜR EINMALIG PROGRAMMIERBARE VORRICHTUNGEN
CIRCUIT ET SYSTÈME D'UTILISATION DE DIODE À JONCTION EN TANT QUE SÉLECTEUR DE PROGRAMME POUR DISPOSITIFS PROGRAMMABLES UNE SEULE FOIS

(30) Priority: 21.09.2013 US 201361880916 P; 18.04.2014 US 201461981212 P; 13.09.2014 US 201414485698
(43) Date of publication of application: 30.05.2018
(62) Divisional of application: 14901820.2
(73) Proprietor: Chung, Shine C., San Jose, California 95120 (US)
(72) Inventor: Chung, Shine C., San Jose, California 95120 (US)
(74) Representative: Alton, Andrew

(56) References cited:
- US-A1- 2013 215 663
- US-B1- 7 405 590
- US-B1- 7 834 659
- TONTI W R: "Reliability, design qualification, and prognostic opportunity of in die E-Fuse", PROGNOSTICS AND HEALTH MANAGEMENT (PHM), 2011 IEEE CONFERENCE ON, IEEE, 20 June 2011 (2011-06-20), pages 1-7, XP031940560, DOI: 10.1109/ICPHM.2011.6024362 ISBN: 978-1-4244-9828-4

## Description

### BACKGROUND OF THE INVENTION

### Field of the Invention

The present invention relates to programmable memory devices, such as programmable resistive devices for use in memory arrays.

### Description of the Related Art

A programmable resistive device is generally referred to a device's resistance states that may change after means of programming. Resistance states can also be determined by resistance values. For example, a resistive device can be a One-Time Programmable (OTP) device, such as electrical fuse, and the programming means can apply a high voltage to induce a high current to flow through the OTP element. When a high current flows through an OTP element by turning on a program selector, the OTP element can be programmed, or burned into a high or low resistance state (depending on either fuse or anti-fuse).

An electrical fuse is a common OTP which is a programmable resistive device that can be constructed from a segment of interconnect, such as polysilicon, silicided polysilicon, silicide, metal, metal alloy, or some combination thereof. The metal can be aluminum, copper, or other transition metals. One of the most commonly used electrical fuses is a CMOS gate, fabricated in silicided polysilicon, used as interconnect. The electrical fuse can also be one or more contacts or vias instead of a segment of interconnect. A high current may blow the contact(s) or via(s) into a very high resistance state. The electrical fuse can be an anti-fuse, where a high voltage makes the resistance lower, instead of higher. The anti-fuse can consist of one or more contacts or vias with an insulator in between. The anti-fuse can also be a CMOS gate coupled to a CMOS body with a thin gate oxide as insulator.

The programmable resistive device can be a reversible resistive device that can be programmed into a digital logic value "0" or "1" repetitively and reversibly. The programmable resistive device can be fabricated from phase change material, such as Germanium(Ge), Antimony(Sb), and Tellurium(Te) with composition Ge₂Sb₂Te₅ (GST-225) or GeSbTe-like materials including compositions of Indium (In), Tin (Sn), or Selenium (Se). Another phase change material can include a chalcogenide material such as AgInSbTe. The phase change material can be programmed into a high resistance amorphous state or a low resistance crystalline state by applying a short and high voltage pulse or a long and low voltage pulse, respectively.

Another type of reversible resistive device is a class of memory called Resistive RAM (RRAM), which is a normally insulating dielectric, but can be made conducting through filament, defects, metal migration, etc. The dielectric can be binary transition metal oxides such as NiO or TiO2, perovskite materials such as Sr(Zr)TiO3 or PCMO, organic charge transfer complexes such as CuTCNQ, or organic donor-acceptor systems such as Al AIDCN. As an example, RRAM can have cells fabricated from metal oxides between electrodes, such as Pt/NiO/Pt, TiN/TiOx/HfO2/TiN, TiN/ZnO/Pt, or W/TiN/SiO2/Si, etc. The resistance states can be changed reversibly and determined by polarity, magnitude, duration, voltage/current-limit, or the combinations thereof to generate or annihilate conductive filaments. Another programmable resistive device similar to RRAM is a Conductive Bridge RAM (CBRAM) that is based on electro-chemical deposition and removal of metal ions in a thin solid-state electrolyte film. The electrodes can be an oxidizable anode and an inert cathode and the electrolyte can be Ag- or Cu-doped chalcogenide glass such as GeSe, Cu2S, or GeS, etc. The resistance states can be changed reversibly and determined by polarity, magnitude, duration, voltage/current-limit, or combinations thereof to generate or annihilate conductive bridges. The programmable resistive device can also be an MRAM (Magnetic RAM) with cells fabricated from magnetic multi-layer stacks that construct a Magnetic Tunnel Junction (MTJ). In a Spin Transfer Torque MRAM (STT-MRAM) the direction of currents applied to an MTJ determines parallel or anti-parallel states, and hence low or high resistance states.

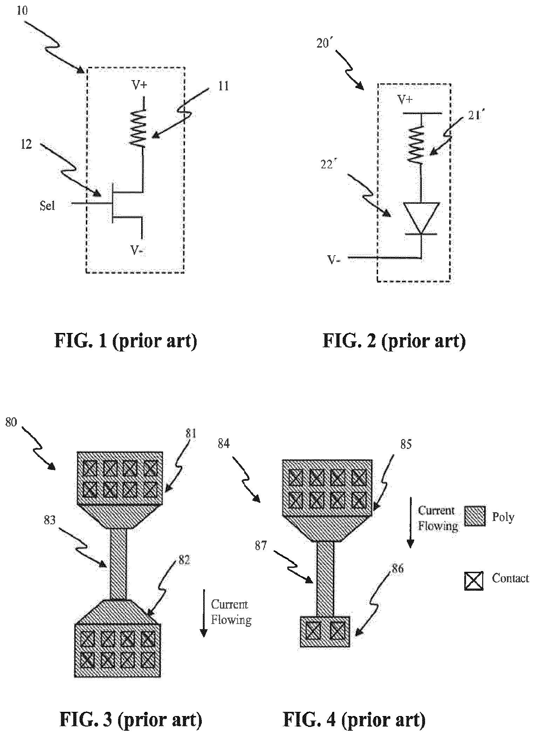

A conventional programmable resistive memory cell 10 is shown in Fig. 1. The cell 10 consists of a resistive element 11 and an NMOS program selector 12. The resistive element 11 is coupled to the drain of the NMOS 12 at one end, and to a high voltage V+ at the other end. The gate of the NMOS 12 is coupled to a select signal (Sel), and the source is coupled to a low voltage V-. When a high voltage is applied to V+ and a low voltage to V-, the resistive cell 10 can be programmed by raising the select signal (Sel) to turn on the NMOS 12. Fig. 2 shows another programmable resistive device cell 20' using a programmable resistive element 21' coupled to a diode 22'. The cathode of the diode 22' can be switched to low to turn on the diode 22' for programming.

Figs. 3 and 4 show several embodiments of an electrical fuse element 80 and 84, respectively, fabricated from an interconnect. The resistive element has three parts: anode, cathode, and body. The anode and cathode provide contacts for the resistive element so that a current can flow from the anode to cathode through the body. The body width determines the current density and hence the electro-migration threshold for a program current. Fig. 3 shows a conventional electrical fuse element 80 with an anode 81, a cathode 82, and a body 83. This embodiment has a large symmetrical anode and cathode. Fig. 4 shows another conventional electrical fuse element 84 with an anode 85, a cathode 86, and a body 87. The fuse elements 80, 84 in Figs. 3 and 4 are relatively large structures which makes them unsuitable for some applications.

US 7405590 describes systems and methods for controlling the programming current directed through a fuse or set of fuses in a device such as an integrated circuit. A method for applying different currents to a set of calibration fuses includes identifying which currents cut the corresponding fuses without destroying them, and selecting one of the identified currents to use in programming one or more target fuses. Fuses that are cut but not destroyed are identified by passing the same read current through each of the calibration fuses and comparing resulting voltages to reference voltages which correspond to impedances between the impedances of the possible fuse states (uncut, cut and destroyed). Fuse voltages between the reference voltages identify fuses which are cut but not destroyed.

US 7834659 describes programming E-fuses in an E-fuse memory array, by: applying a first programming pulse to a plurality of E-fuses to program the plurality of E-fuses to a first state; and then applying a second programming pulse to at least a selected E-fuse in the plurality of E-fuses to program the selected E-fuse to a second state.

A first aspect of the invention provides a method of programming One-Time Programmable (OTP) memory according to claim 1.

A second aspect of the invention provides a method of programming One-Time Programmable (OTP) memory according to claim 16.

A third aspect of the invention provides a One-Time Programmable (OTP) memory according to claim 19.

### BRIEF DESCRIPTION OF THE DRAWINGS

The present invention will be readily understood by the following detailed descriptions in conjunction with the accompanying drawings, wherein like reference numerals designate like structural elements, and in which:
Fig. 1 shows a conventional programmable resistive memory cell.
Fig. 2 shows another programmable resistive device cell using diode as program selector.
Figs. 3 and 4 show several embodiments of an electrical fuse element, respectively, fabricated from an interconnect.
Fig. 5(a) shows a block diagram of a memory cell using a junction diode according to one embodiment.

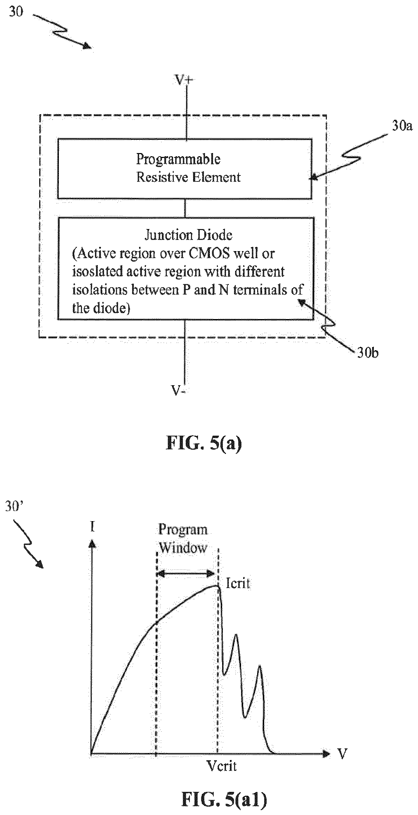

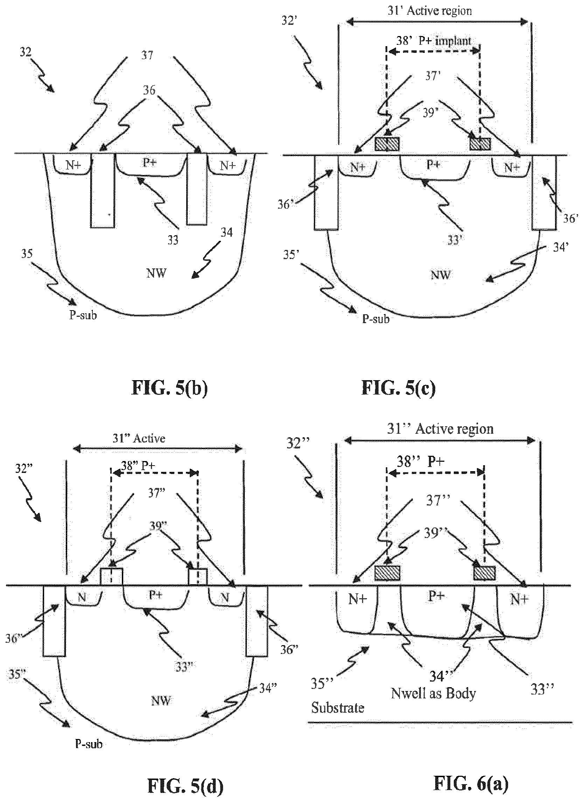

Fig. 5(a1) shows I-V characteristics of programming an electrical fuse reliably according to one embodiment.
Fig. 5(b) shows a cross section of junction diodes as program selector with STI isolation according to one embodiment.
Fig. 5(c) shows a cross section of junction diodes as program selector with dummy CMOS gate isolation according to one embodiment.
Fig. 5(d) shows a cross section of junction diodes as program selector with SBL isolation according to one embodiment.

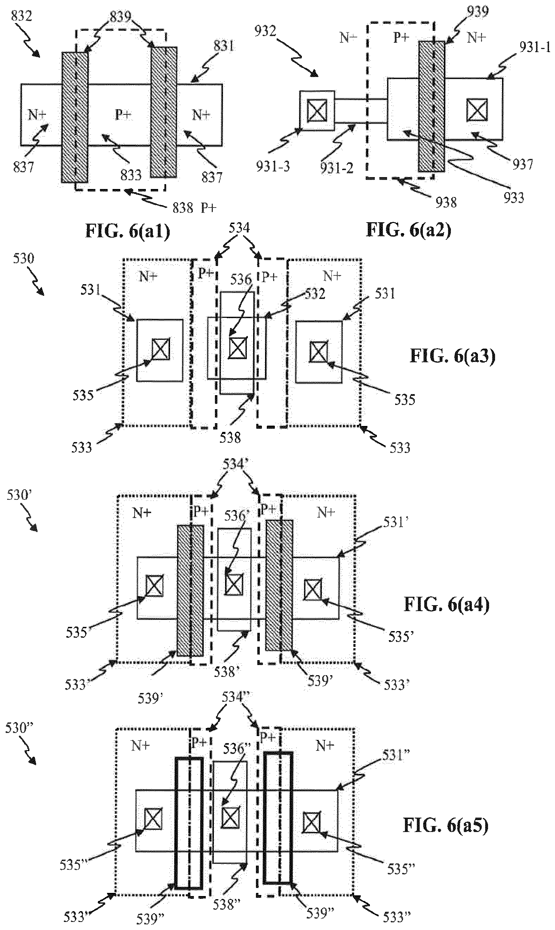

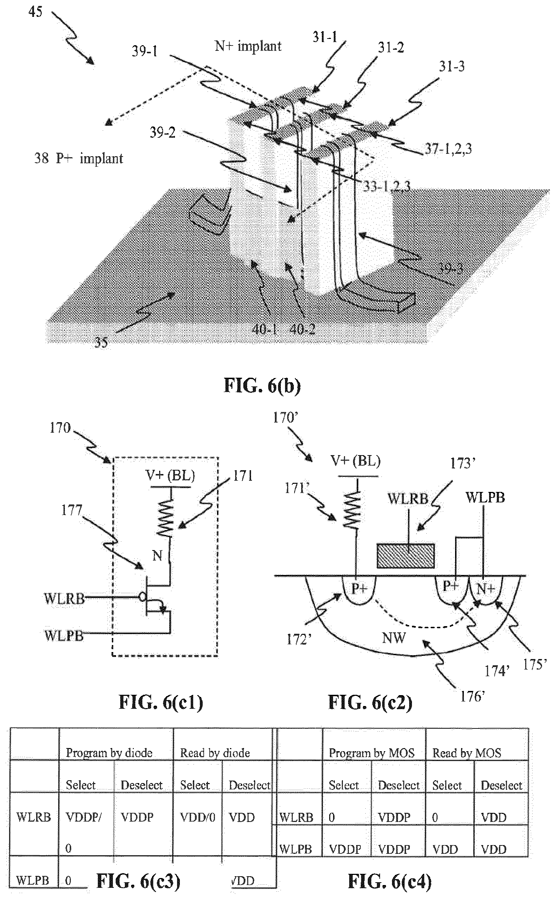

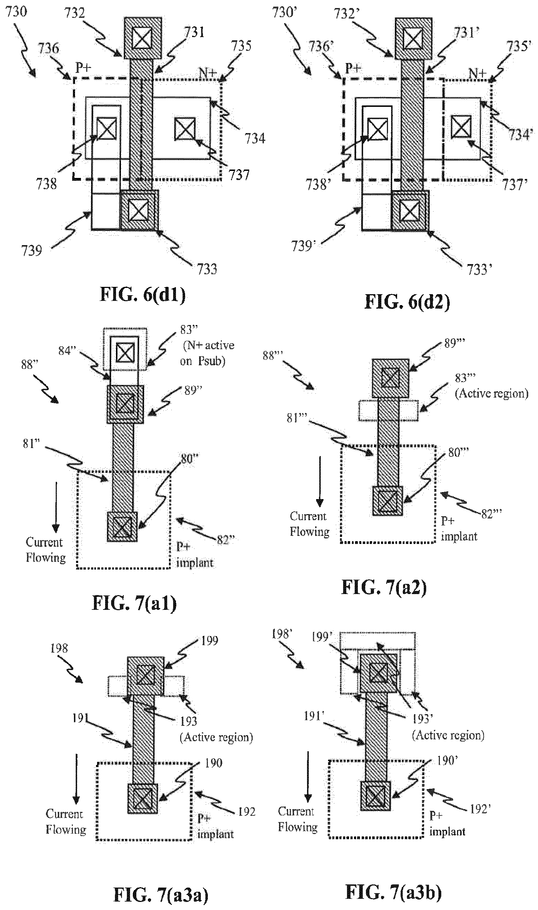

Fig. 6(a) shows a cross section of junction diodes as program selector with dummy CMOS gate isolation in SOI technologies according to one embodiment.
Fig. 6(a1) shows a top view of junction diodes as program selector with dummy CMOS gate isolation in SOI or similar technologies according to one embodiment.
Fig. 6(a2) shows a top view of a programmable resistive cell having a resistive element and a diode as program selector in one piece of an isolated active region with dummy gate isolation in the two terminals of the diode, according to one embodiment.
Fig. 6(a3) shows a top view of a Schottky diode with STI isolation as a program selector according to one embodiment.
Fig. 6(a4) shows a top view of a Schottky diode with CMOS gate isolation as a program selector according to one embodiment.
Fig. 6(a5) shows a top view of a Schottky diode with Silicide Block Layer (SBL) isolation as a program selector according to one embodiment.
Fig. 6(b) shows a 3D view of junction diodes as program selector with dummy CMOS gate isolation in FINFET technologies according to one embodiment.
Fig. 6(c1) shows a schematic of a programmable resistive cell with a PMOS configured as diode or MOS during program or read according to one embodiment.
Fig. 6(c2) shows a cross section of a programmable resistive cell with a PMOS configured as diode or MOS during program or read, corresponding to the programmable resistive cell in Fig. 6(c1), according to one embodiment.
Fig. 6(c3) shows operation conditions of a programmable resistive cell with a PMOS configured as diode for program and read selector, corresponding to the programmable resistive cell in Fig. 6(c1), according to one embodiment.
Fig. 6(c4) shows operation conditions of a programmable resistive cell with a PMOS configured MOS for program and read selector, corresponding to the programmable resistive cell in Fig. 6(c1), according to one embodiment.
Fig. 6(d1) shows a programmable resistive cell using a dummy gate of a program selector as a PRD element in a thermally insolated substrate, according to one embodiment.
Fig. 6(d2) shows a programmable resistive cell using a MOS gate of a program selector as a PRD element in a thermally insolated substrate, according to another embodiment.

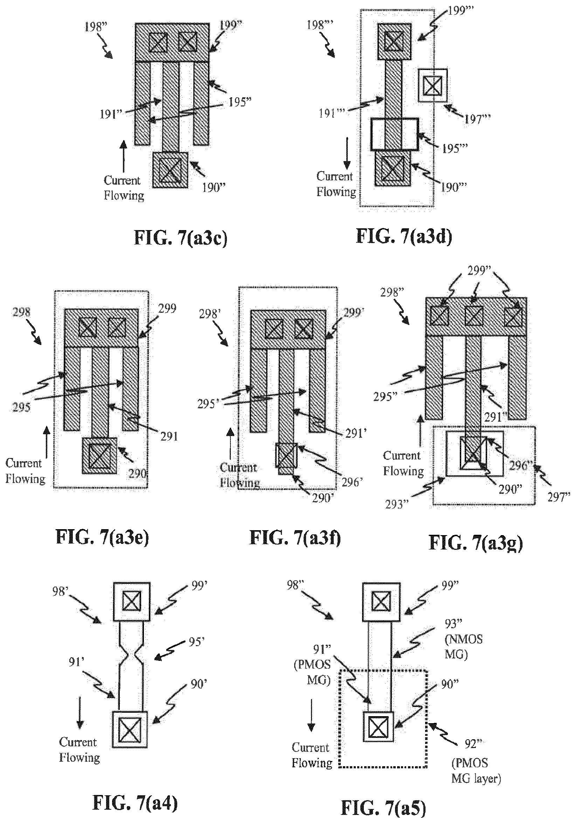

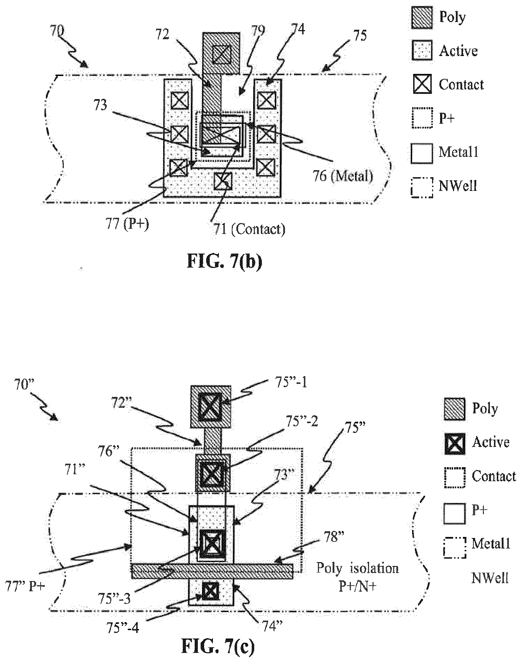

Fig. 7(a1) shows an electrical fuse element using a thermally conductive but electrically insulated area near the anode as a heat sink according to another embodiment.
Fig. 7(a2) shows an electrical fuse element using a thinner oxide underneath the body and near the anode as a heat sink according to another embodiment.
Fig. 7(a3a) shows an electrical fuse element using thin oxide areas underneath the anode as heat sinks according to yet another embodiment.
Fig. 7(a3b) shows an electrical fuse element using a thin oxide area near to the anode as a heat sink according to yet another embodiment.
Fig. 7(a3c) shows an electrical fuse element using an extended anode as a heat sink according to yet another embodiment..
Fig. 7(a3d) shows an electrical fuse element using a high resistance area as a heat generator according to one embodiment.
Fig. 7(a3e) shows an electrical fuse element with an extended area in the cathode according to one embodiment.
Fig. 7(a3f) shows an electrical fuse element with an extended area in the cathode and a borderless contact in the anode according to one embodiment.
Fig. 7(a3g) shows an electrical fuse element with an extended area in the cathode and a shared contact in the anode according to one embodiment.
Fig. 7(a4) shows an electrical fuse element with at least one notch according to another embodiment.
Fig. 7(a5) shows an electrical fuse element with part NMOS metal gate and part PMOS metal gate according to another embodiment.
Fig. 7(b) shows a top view of an abutted contact coupled between a resistive element, P terminal of a junction diode, and metal in a single contact, according to one embodiment.
Fig. 7(c) shows a top view of a programmable resistive cell coupled to a junction diode with dummy CMOS gate isolation between P+/N+ active regions, according to one embodiment.

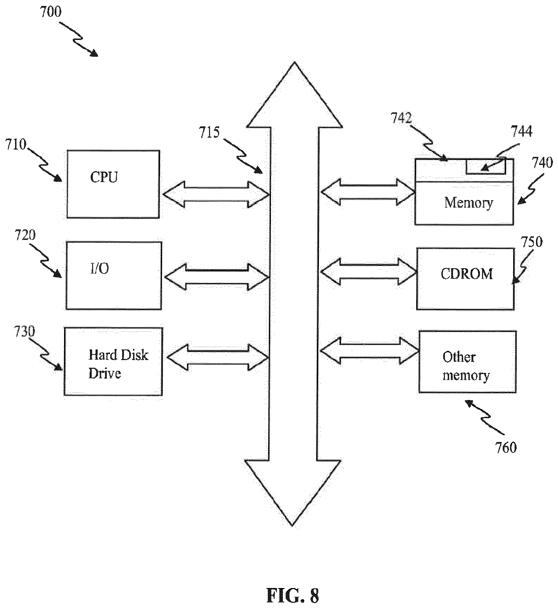

Fig. 8 shows a processor system according to one embodiment.

### DETAILED DESCRIPTION OF EMBODIMENTS OF THE INVENTION

Embodiments disclosed herein use a P+/N well junction diode as program selector for a programmable resistive device. The diode can comprise P+ and N+ active regions on an N well. Since the P+ and N+ active regions and N well are readily available in standard CMOS logic processes, these devices can be formed in an efficient and cost effective manner. For standard Silicon-On-Insulator (SOI), FinFET, or similar technologies, isolated active regions can be used to construct diodes as program selectors or as programmable resistive elements. The programmable resistive device can also be included within an electronic system.

In one or more embodiments, junction diodes can be fabricated with standard CMOS logic processes and can be used as program selectors for One-Time Programmable (OTP) devices. The OTP devices can include electrical fuse are programmable elements. Examples of electrical fuses include interconnect fuse, contact/via fuse, contact/via anti-fuse, gate-oxide breakdown anti-fuse, etc. At least one heat sink, heat generator, or extended area can be built in a programmable resistive device (PRD) to assist programming. A heat sink can include at least one conductor built in or near to a PRD element to dissipate heat fast. A heat generator can include at least one high resistance material in the current path to generate more heat. An interconnect, a conductive jumper, a single or a plurality of contact or via can be used as a heat generator. An extended area is an area in the PRD element where there is reduced or no current flow through. If a metal fuse is used as an electrical fuse, at least one contact and/or a plurality of vias can be built (possibly with use of one or more jumpers) in the program path to generate more Joule heat to assist with programming. The jumpers are conductive and can be formed of metal, metal gate, local interconnect, polymetal, etc. The OTP device can have at least one OTP element coupled to at least one diode in a memory cell. The diode can be constructed by P+ and N+ active regions in a CMOS N well, or on an isolated active region as the P and N terminals of the diode. The OTP element can be polysilicon, silicided polysilicon, silicide, polymetal, metal, metal alloy, local interconnect, thermally isolated active region, CMOS gate, or combination thereof.

Embodiments of the invention are discussed below with reference to the figures. However, those skilled in the art will readily appreciate that the detailed description given herein with respect to these figures is for explanatory purposes as the scope of the invention is defined by the appended claims.

Fig. 5(a) shows a block diagram of a memory cell 30 using at least a junction diode according to one embodiment. In particular, the memory cell 30 includes a resistive element 30a and a junction diode 30b. The resistive element 30a can be coupled between an anode of the junction diode 30b and a high voltage V+. A cathode of the junction diode 30b can be coupled to a low voltage V-. In one implementation, the memory cell 30 can be a fuse cell with the resistive element 30a operating as an electrical fuse. The junction diode 30b can serve as a program selector. The junction diode can be constructed from a P+/N well in standard CMOS processes using a P type substrate or on an isolated active region in an SOI or FinFET technologies. The P+ and N+ active regions serve as the anode and cathode of the diode are the sources or drains of CMOS devices. The N well is a CMOS well to house PMOS devices. Alternatively, the junction diode can be constructed from N+/P well in triple-well or CMOS processes using an N type substrate. The coupling of the resistive element 30a and the junction diode 30b between the supply voltages V+ and V- can be interchanged. By applying a proper voltage between V+ and V- for a proper duration of time, the resistive element 30a can be programmed into high or low resistance states, depending on voltage and duration, thereby programming the memory cell 30 to store a data value (e.g., bit of data). The P+ and N+ active regions of the diode can be isolated by using a dummy CMOS gate, Shallow Trench Isolation (STI) or Local Oxidation (LOCOS), or Silicide Block Layer (SBL).

Fig. 5(a1) shows an I-V characteristic of programming an electrical fuse according to one embodiment of the present invention. The I-V characteristic shows a voltage applied to the electrical fuse in the X-axis and the responding current is shown in the Y-axis. When the current is very low, the slope of the curve is the inversion of the initial resistance. As the current is increased, the resistance is increased due to Joule heat so that the curve bends toward X-axis if the temperature coefficient is positive. At a critical point, Icrit, the resistance of the electrical fuse changes drastically (or can even become negative) due to rupture, decomposition, melt, or thermal run away. The conventional way of programming an electrical fuse is by applying a current higher than Icrit such that the programming behavior is like an explosion and the resultant resistance is highly unpredictable. On the other hand, if a programming current is below Icrit, the programming mechanism is solely based on electromigration such that the programming behavior is very controllable and deterministic. An electrical fuse can be programmed by applying multiple voltage or current pulses with progressive resistance changes until a satisfactory high resistance can be reached and sensed. The post-program yield is 100% practically so that the total yield can be determined by pre-program yield which depends on the pre-program fabrication defects. As a result, programming an electrical fuse can be very reliable. The I-V characteristics in Fig. 5(a1) is also applicable for an OTP cell that includes OTP element and a selector. Further, the program status, whether an electrical fuse is programmed or not, is not clearly visible by optical microscope or scanning electronic microscope (SEM).

A method of programming a fuse reliably according to an embodiment of the invention includes the following steps: (a) starting with a low program voltage initially to program a portion of an OTP memory and incrementing the program voltage until all OTP cells can be programmed and read verified, marked this voltage as a low bound of the program voltage, (b) continuously incrementing the program voltage to program the same portion of OTP cells until at least one OTP cell, whether programmed or not, is read verified failure, marked this voltage as a high bound of the program voltage. Furthermore, the program time can be adjusted to characterize the program window by repeating the above steps (a) and (b) accordingly until a low bound, high bound, or program window (voltage range between high and low bound) meets a target value. The window of programming an electrical fuse reliably is marked in Fig. 5(a1). After characterizing the program window, the other OTP cells can be programmed with a voltage between the low and high bounds in one pulse only.

A method of measuring the cell current can include the following steps: (a) applying a voltage to a program pad VDDP in the program mode, low enough that can not program the OTP cells, (b) preventing the VDDP from supply current to the OTP macro other than the OTP memory array, (c) turning on the selector of the OTP cell to be measured, (d) measuring the current flowing through the VDDP pad as the cell current of the selected OTP cell. This method is applicable to those OTP cells that have been programmed or not. This method can also be used as a criteria to determine whether an OTP cell is verified as being in an un-programmed state or a programmed state by using a maximum cell current for programmed and a minimum cell current for un-programmed, respectively, to determine the low and high bounds of a program voltage during characterization.

Electrical fuse cell can be used as an example to illustrate the key concepts according to one embodiment. Fig. 5(b) shows a cross section of a diode 32 using a P+/N well diode as program selector with Shallow Trench Isolation (STI) isolation in a programmable resistive device. P+ active region 33 and N+ active region 37, constituting the P and N terminals of the diode 32 respectively, are sources or drains of PMOS and NMOS in standard CMOS logic processes. The N+ active region 37 is coupled to an N well 34, which houses PMOS in standard CMOS logic processes. P substrate 35 is a P type silicon substrate. STI 36 isolates active regions for different devices. A resistive element (not shown in Fig. 5(b)), such as electrical fuse, can be coupled to the P+ region 33 at one end and to a high voltage supply V+ at the other end. To program this programmable resistive device, a high voltage is applied to V+, and a low voltage or ground is applied to the N+ region 37. As a result, a high current flows through the fuse element and the diode 32 to program the resistive device accordingly.

Fig. 5(c) shows a cross section of another embodiment of a junction diode 32' as program selector with dummy CMOS gate isolation. Shallow Trench Isolation (STI) 36' provides isolation among active regions. An active region 31' is defined between STI 36', where the N+ and P+ active regions 37' and 33' are further defined by a combination of a dummy CMOS gate 39', P+ implant layer 38', and N+ implant (the complement of the P+ implant 38'), respectively, to constitute the N and P terminals of the diode 32'. The dummy CMOS gate 39' is a CMOS gate fabricated in standard CMOS process. The width of dummy gate 39' can be close to the minimum figure width of a CMOS gate and can also be less than twice the minimum figure width. The dummy MOS gate can also be created with a thicker gate oxide. The diode 32' is fabricated as a PMOS-like device with 37', 39', 33', and 34' as source, gate, drain, and N well, except that the source 37' is covered by an N+ implant, rather than a P+ implant 38'. The dummy MOS gate 39', preferably biased at a fixed voltage or coupled to the N+ active region 37', only serves for isolation between P+ active region 33' and N+ active region 37' during fabrication. The N+ active 37' is coupled to an N well 34', which houses PMOS in standard CMOS logic processes. P substrate 35' is a P type silicon substrate. A resistive element (not shown in Fig. 5(c)), such as electrical fuse, can be coupled to the P+ region 33' at one end and to a high voltage supply V+ at the other end. To program this programmable resistive device, a high voltage is applied to V+, and a low voltage or ground is applied to the N+ active region 37'. As a result, a high current flows through the fuse element and the diode 32' to program the resistive device accordingly. This embodiment is desirable for isolation for small size and low resistance.

Fig. 5(d) shows a cross section of another embodiment of a junction diode 32" as program selector with Silicide Block Layer (SBL) isolation. Fig. 5(d) is similar to 5(c), except that the dummy CMOS gate 39" in Fig. 5(c) is replaced by SBL 39" in Fig. 5(d) to block a silicide grown on the top of active region 31". Without a dummy MOS gate or a SBL, the N+ and P+ active regions would be undesirably electrically shorted by a silicide on the surface of the active region 31".

Fig. 6(a) shows a cross section of another embodiment of a junction diode 32" as a program selector in Silicon-On-Insulator (SOI), FinFET, or similar technologies. In SOI technologies, the substrate 35" is an insulator such as SiO₂ or similar material with a thin layer of silicon grown on top. All NMOS and PMOS are in active regions isolated by SiO₂ or similar material to each other and to the substrate 35". An active region 31" is divided into N+ active regions 37", P+ active region 33", and bodies 34" by a combination of a dummy CMOS gate 39", P+ implant 38", and N+ implant (the complement of P+ implant 38"). Consequently, the N+ active regions 37" and P+ active region 33" constitute the N and P terminals of the junction diode 32". The N+ active regions 37" and P+ active region 33" can be the same as sources or drains of NMOS and PMOS devices, respectively, in standard CMOS processes. Similarly, the dummy CMOS gate 39" can be the same CMOS gate fabricated in standard CMOS processes. The dummy MOS gate 39", which can be biased at a fixed voltage or coupled to the N+ region 37", only serves for isolation between P+ active region 33" and N+ active region 37" during fabrication. The width of the dummy MOS gate 39" can vary but can, in one embodiment, be close to the minimum gate width of a CMOS gate and can also be less than twice the minimum width. The dummy MOS gate can also be created with a thicker gate oxide to sustain higher voltage. The N+ active regions 37" can be coupled to a low voltage supply V-. A resistive element (not shown in Fig. 6(a)), such as an electrical fuse, can be coupled to the P+ active region 33" at one end and to a high voltage supply V+ at the other end. To program the electrical fuse cell, a high and a low voltages are applied to V+ and V-, respectively, to conduct a high current flowing through the resistive element and the junction diode 32" to program the resistive device accordingly. Other embodiments of isolations in CMOS bulk technologies, such as dummy MOS gate, or SBL in one to four (1-4) or any sides or between cells, can be readily applied to CMOS SOI technologies accordingly.

Fig. 6(a1) shows a top view of one embodiment of a junction diode 832, corresponding to the cross section as shown in Fig. 6(a), constructed from an isolated active region as a program selector in Silicon-On-Insulator (SOI), FinFET, or similar technologies. One active region 831 is divided into N+ active regions 837, P+ active region 833, and bodies underneath dummy gate 839 by a combination of a dummy CMOS gate 839, P+ implant 838, and N+ implant (the complement of P+ implant 838).

Fig. 6(a2) shows a top view of one embodiment of a fuse cell 932 constructed from a fuse element 931-2, a diode 931-1 as program selector in one piece of an isolated active region, and a contact area 931-3. These elements/regions (931-1, 931-2, and 931-3) are all isolated active regions built on the same structure to serve as a diode, fuse element, and contact area of a fuse cell 932. The isolated active region 931-1 is divided by a CMOS dummy gate 939 into regions 933 and 937 that are further covered by P+ implant 938 and N+ implant (the complement of the P+ implant 938) to serve as P and N terminals of the diode 931-1. The P+ 933 is coupled to a fuse element 931-2, which is further coupled to the contact area 931-3. The contact area 931-3 and the contact area for cathode of the diode 931-1 can be coupled to V+ and V- supply voltage lines, respectively, through a single or plural of contacts. When high and low voltages are applied to V+ and V-, respectively, a high current can flow through the fuse element 931-2 to program the fuse into a high resistance state. In one implementation, the fuse element 931-2 can be all N or all P. In another implementation, the fuse element 931-2 can be half P and half N so that the fuse element can behave like a reverse-biased diode during read, when the silicide on top is depleted after program. If there is no silicide available, the fuse element 931-2, which is an OTP element, can be constructed as N/P or P/N diodes for breakdown in the forward or reverse biased condition. In this embodiment, the OTP element can be coupled directly to a diode as program selector without any contacts in between. Thus, the cell area can be small and its cost can be relatively low.

The diode as a program selector can be made of Schottky diode in standard CMOS processes as shown in Figs 6(a3)-6(a5). The Schottky diode is a metal to semiconductor diode, instead of a junction diode that is fabricated from the same semiconductor material but with N+ and P+ dopants in two terminals. The top view of a Schottky diode as a program selector can be very similar to that of a junction diode, except the anode of the diode is a metal to a lightly doped N or P type dopant, which is different from a heavily P+ doped in a junction diode. The anode of the Schottky diode can be made of any kinds of metals, such as aluminum or copper, metal alloys, or silicides in other embodiments. The Schottky diode can be a metal to N+ active on N well or P+ active on P well. The Schottky diode can be fabricated in bulk or SOI CMOS, planar or FinFET CMOS in other embodiments. There are many variations but equivalent embodiments of fabricating Schottky diodes that are still within the scope of this invention for those skilled in the art.

Fig. 6(a3) shows a top view of a Schottky diode 530 according to one embodiment. The Schottky diode 530 can be formed inside an N well (not shown) has active regions 531 as the cathode and an active region 532 as the anode. The active regions 531 are covered by N+ implant 533 with a contact 535 coupled to an external connection. The active region 532 is not covered by N+ or P+ implant so that the doping concentration of the active region 532 is substantially the same as the doping concentration of the N well. A silicide layer can be formed on top of the active region 532 to form a Schottky barrier with the silicon, which is further coupled to a metal 538 through an anode contact 536. A P+ implant 534 can overlap into the active region 532 to reduce leakage. In other embodiment, the P+ implant 534 can be omitted.

Fig. 6(a4) shows a top view of a Schottky diode 530' according to one embodiment. The Schottky diode 530' can be formed inside an N well (not shown) has an active region 531 to house the anode and cathode of the diode. The active region 531' is divided by dummy gates 539' into a central anode and two outside cathode areas. The cathode areas are covered by an N+ implant 533' with a contact 535' coupled to external connection. The central anode is not covered by N+ or P+ implant so that the doping concentration of the active region 532 is substantially the same as the doping concentration of the N well. A silicide layer can be formed on top of the central anode region to form a Schottky barrier with the silicon, which is further coupled to a metal 538' through an anode contact 536'. A P+ implant 534' can overlap into the central active region to reduce leakage. The boundary of N+ 533' and P+ 534' can fall on the cathode areas in other embodiment. The P+ implant 534' can be omitted in another embodiment.

Fig. 6(a5) shows a top view of a Schottky diode 530" according to one embodiment. The Schottky diode 530" can be formed inside an N well (not shown) has an active region 531" to house the anode and cathode of the diode. The active region 531" is divided by Silicide Block Layers (SBL) 539" into a central anode and two outside cathode areas. The cathode areas are covered by an N+ implant 533" with a contact 535" coupled to external connection. The central anode 532" is not covered by N+ or P+ implant so that the doping concentration of the active region 532" is substantially the same as the doping concentration of the N well. A silicide layer can be formed on top of the central anode region to form a Schottky barrier with the silicon, which is further coupled to a metal 538" through an anode contact 536". A P+ implant region 534" can overlap into the anode region to reduce leakage. In other embodiment, the P+ implant 534" can be omitted.

Fig. 6(b) shows a cross section of another embodiment of a diode 45 as a program selector in FinFET technologies. FinFET refers to a fin-based, multigate transistor. FinFET technologies are similar to the conventional CMOS except that thin and tall silicon islands can be raised above the silicon substrate to serve as the bulks of CMOS devices. The bulks are divided into source, drain, and channel regions by polysilicon or non-aluminum metal gates like in the conventional CMOS. The primary difference is that the MOS devices are raised above the substrate so that channel widths are the height of the islands, though the direction of current flow is still in parallel to the surface. In an example of FinFET technology shown in Fig. 6(b), the silicon substrate 35 is an epitaxial layer built on top of an insulator like SOI or other high resistivity silicon substrate. The silicon substrate 35 can then be etched into several tall rectangular islands 31-1, 31-2, and 31-3. With proper gate oxide grown, the islands 31 - 1, 31-2, and 31-3 can be patterned with MOS gates 39-1, 39-2, and 39-3, respectively, to cover both sides of raised islands 31-1, 31-2, and 31-3 and to define source and drain regions. The source and drain regions formed at the islands 31-1, 31-2, and 31-3 are then filled with silicon/SiGe called extended source/drain regions, such as 40-1 and 40-2, so that the combined source or drain areas can be large enough to allow contacts. The extended source/drain can be fabricated from polysilicon, polycrystalline Si/SiGe, lateral epitaxial growth silicon/SiGe, or Selective Epixatial Growth (SEG) of Silicon/SiGe, etc. The extended source/drain regions 40-1 and 40-2, or other types of isolated active regions, can be grown or deposited to the sidewall or the end of the fins. The fill 40-1 and 40-2 areas in Fig. 6(b) are for illustrative purpose to reveal the cross section and can, for example, be filled up to the surface of the islands 31-1, 31-2, and 31-3. In this embodiment, active regions 33-1,2,3 and 37-1,2,3 are covered by a P+ implant 38 and N+ implant (the complement of P+ implant 38), respectively, rather than all covered by P+ implant 38 as PMOS in the conventional FinFET, to constitute the P and N terminals of the junction diode 45. The N+ active regions 37-1,2,3 can be coupled to a low voltage supply V-. A resistive element (not shown in Fig. 6(b)), such as an electrical fuse, can be coupled to the P+ active region 33-1,2,3 at one end and to a high voltage supply V+ at the other end. To program the electrical fuse, high and low voltages are applied between V+ and V-, respectively, to conduct a high current flowing through the resistive element and the junction diode 45 to program the resistive device accordingly. Other embodiments of isolations in CMOS bulk technologies, such as STI, dummy MOS gate or SBL, can be readily applied to FinFET technologies accordingly.

Figs. 6(a), 6(a1), 6(a2), and 6(b) shows various schemes of constructing diodes as program selector and/or OTP element in a fully or partially isolated active region. A diode as program selector can be constructed from an isolated active region such as in SOI or FINFET technologies. The isolated active region can be used to construct a diode with two ends implanted with P+ and N+, the same implants as the source/drain implants of CMOS devices, to serve as two terminals of a diode. A dummy CMOS gate or silicide block layer (SBL) can be used for isolation and to prevent shorting of the two terminals. In the SBL isolation, the SBL layer can overlap into the N+ and P+ implant regions and the N+ and P+ implant regions can be separated with a space. The width and/or the doping level in the space region can be used to adjust the diode's breakdown voltage or leakage current accordingly. A fuse as OTP element can also be constructed from an isolated active region. Since the OTP element is thermally isolated, the heat generated during programming cannot be dissipated easily so that the temperature can be raised higher to accelerate programming. The OTP element can have all N+ or all P+ implant. If there is a silicide on top of the active region, the OTP element can have part N+ and part P+ implants so that the OTP element can behave like a reverse biased diode during read, such as when the silicide is depleted after OTP programming in one embodiment. If there is no silicide on top, the OTP element can have part N+ and part P+ implants as a diode to be breakdown during OTP programming in another embodiment. In either case, the OTP element or diode can be constructed on the same structure of an isolated active region to save area. In an SOI or FinFET SOI technology, an active region can be fully isolated from the substrate and from other active regions by SiO₂ or similar material. Similarly, in a FINFET bulk technology, active regions in the fin structures built on the same silicon substrate are isolated from each other above the surface. Those active regions can be coupled together by using extended source/drain regions.

Fig. 6(c1) shows a schematic of using at least one PMOS configured as diode or MOS for program or read selector according to one embodiment. The programmable resistance device cell 170 has a programmable resistive element 171 coupled to a PMOS 177. The PMOS 177 has a gate coupled to a read wordline bar (WLRB) and a drain coupled to a program wordline bar (WLPB), a source coupled to the programmable resistive element 171, and a bulk coupled to the drain. The PMOS 177 can have the source junction conducted to behave like a diode for the selected cells during programming. The PMOS 177 can also have the source junction or the channel conducted to behave like a diode or MOS selector, respectively, during read.

Fig. 6(c2) shows a cross section of the cell in Fig. 6(c1) to further illustrate the program and read path using at least one PMOS as a selector configured as diode or MOS for program or read selector according to one embodiment. The programmable resistive device cell 170' has a programmable resistive element 171' coupled to a PMOS that consists of a source 172', gate 173', drain 174', N well 176', and N well tap 175'. The PMOS has a special conduction mode that is hard to find in the ordinary CMOS digital or analog designs by pulling the drain 174' to a very low voltage (e.g. ground) to turn on the junction diode in the source 172' for programming as shown in a dash line. Since the diode has an I-V characteristic of exponential law than square law in MOS, this conduction mode can deliver high current to result in smaller cell size and low program voltage. The PMOS can be turned on during read to achieve low voltage read.

The operation conditions of the cells in Fig. 6(c1) and 6(c2) are further described in Fig. 6(c3) and 6(c1) to illustrate the novelty of the particular cells. Fig. 6(c3) shows operation conditions of programming and reading by diode. During programming, the selected cell can have WLPB coupled to a very low voltage (i.e. ground) to turn on the source junction diode, while the WLRB can be either coupled to VDDP, the program voltage, or ground. The WLPB and WLRB of the unselected cells can be both coupled to VDDP. During reading, the selected cell can have the WLRB coupled to VDD core voltage or ground and the WLPB coupled to ground to turn on the source junction diode of PMOS 171 in Fig. 6(c1). The WLPB and WLRB of the unselected cells are coupled to VDD. Fig. 6(c1) shows the operation conditions of programming and reading by MOS. The operation conditions in this figure are similar to those in Fig. 6(c3) except that the WLRB and WLPB of the selected cells are coupled to 0 and VDD/VDDP, respectively, during read/program. Thus, the PMOS is turned on during programming or reading. The PMOS can be drawn in a layout like a conventional PMOS, but the operation voltages applied to the PMOS terminals are quite different from conventional operations. In other embodiments, combinations of diode and/or MOS for programming or read can be achieved, such as programming by diode and reading by MOS in one embodiment or programming by diode and MOS in different current directions for different data in another embodiment, for example. In yet another embodiment, the MOS can be created with a thicker oxide than that in core devices to sustain high voltage.

Fig. 6(d1) shows a top view of a programmable resistive device (PRD) cell 730 built on a thermally insulated substrate, such as SOI or polysilicon. In a thermally insulated substrate the heat conductivity is poor such that the programmable resistive element (PRE) can be shared with the gate of a program selector and still keeps high program efficiency. The cell 730 has a PRE with body 731, anode 732, and cathode 733. The body of the PRE 731 is also the gate of a dummy-gate diode including an active region 734, a cathode with an N+ implant 735 and a cathode contact 737, and an anode with a P+ implant 736 and an anode contact 738. The cathode 733 of the PRE is coupled to the anode of the dummy-gate diode by a metal 739.

Fig. 6(d2) shows a top view of a programmable resistive device (PRD) cell 730' built on a thermally insulated substrate, such as SOI or polysilicon. In a thermally insulated substrate the heat conductivity is poor such that the programmable resistive element (PRE) can be shared with the gate of a program selector and still keeps high program efficiency. The cell 730' has a PRE with body 731', anode 732', and cathode 733'. The body 731' of the PRE is also the gate of a MOS including an active region 734', a drain with a drain contact 737' covered by an N+ implant 735' and a source with a contact 738' covered by a P+ implant 736'. The cathode 733' of the PRE is coupled to the source contact 738' of the MOS by a metal 739'. The PRD cell 730' can be programmed or read by turning on the source junction diode of the MOS, similar to the operations from Figs. 6(c1)-6(c4).

The PRD cells 730 and 730' shown in Fig. 6(d1) and 6(d2) are for illustrative purposes. The thermally insulated substrate can be a Silicon-On-Insulator (SOI) or a polysilicon substrate. The active area can be silicon, Ge, SiGe, III-V, or II-VI semiconductor material. The PRE can be an electrical fuse (including anti-fuse), PCM thin film, RRAM film, etc. The PRE can be built with heat sink as shown in Figs. 7(a1), 7(a3a)-7(a3c), heat source as shown in Figs. 7(a2) or 7(a3d), or extended area as shown in Figs. 7(a3e)-7(a3g). The program selector can be a diode or a MOS. The MOS selector can be programmed or read by turning on a MOS channel or a source junction. There are many combinations and equivalent embodiments of this concept and they all fall within the scope of this invention for those skilled in the art.

Fig. 7(a1) shows a top view of an electrical fuse element 88" according to another embodiment. The electrical fuse element 88" is using a thermally conductive but electrically insulated heat sink coupled to the anode. The electrical fuse element 88" can, for example, be used as the resistive element 31a illustrated in Fig. 5(a). The electrical fuse element 88" can include an anode 89", a cathode 80", a body 81", and an N+ active region 83". The N+ active region 83" on a P type substrate is coupled to the anode 89" through a metal 84". In this embodiment, the N+ active region 83" is electrically insulated from the conduction path (i.e. N+/P sub diode is reverse biased) but thermally conductive to the P substrate that can serve as a heat sink. In other embodiment, the heat sink can be coupled to the anode 89" directly without using any metal or interconnect, and can be close to or underneath the anode. The heat sink can also be coupled to the body, cathode, or anode in part or all of a fuse element in other embodiments. This embodiment of heat sink can create a steep temperature gradient to accelerate programming. In another embodiment, the body can be bent 45 or 90-degrees once or more than once.

Fig. 7(a2) shows a top view of an electrical fuse element 88"' according to another embodiment. The electrical fuse element 88"' is similar to the one shown in Fig. 7(a1) except a thinner oxide region 83'" which serves as a heat sink underneath the body 81" and near the anode 89"'. The electrical fuse element 88'" can, for example, be used as the resistive element 31a illustrated in Fig. 5(a). The electrical fuse element 88"' includes an anode 89"', a cathode 80"', a body 81"', and an active region 83"' near the anode 89"'. The active region 83'" underneath the fuse element 81'" makes the oxide thinner in the area than the other (i.e., thin gate oxide instead of thick STI oxide). The thinner oxide above the active region 83'" can dissipate heat faster to create a temperature gradient to accelerate programming. In other embodiments, the thin oxide area 83'" can be placed underneath the cathode, body, or anode in part or all of a fuse element as a heat sink.

Fig. 7(a3a) shows a top view of an electrical fuse element 198 according to another embodiment. The electrical fuse element 198 is similar to the one shown in Fig. 7(a1) except thinner oxide regions 193 are placed in two sides of the anode 199 as another form of heat sink. The electrical fuse element 198 can, for example, be used as the resistive element 31a illustrated in Fig. 5(a). The electrical fuse element 198 includes an anode 199, a cathode 190, a body 191, and an active region 193 near the anode 199. The active region 193 underneath the anode 199 makes the oxide thinner in the area than the other (i.e., thin gate oxide instead of thick STI oxide).

Fig. 7(a3b) shows a top view of an electrical fuse element 198' according to another embodiment. The electrical fuse element 198' is similar to the one shown in Fig. 7(a1) except thinner oxide regions 193' are placed close to the anode 199' as another form of heat sink. The electrical fuse element 198' can, for example, be used as the resistive element 31a illustrated in Fig. 5(a). The electrical fuse element 198' includes an anode 199', a cathode 190', a body 191', and an active region 193' near the anode 199'. The active region 193' close to the anode 199' of the fuse element 198' makes the oxide thinner in the area than the other (i.e., thin gate oxide instead of thick STI oxide) and can dissipate heat faster to create a temperature gradient to accelerate programming. In other embodiment, the thin oxide area can be placed near to the cathode, body, or anode of a fuse element in one, two, three, four, or any sides to dissipate heat faster. In other embodiment, there can be at least one substrate contact coupled to an active region, such as 193', to prevent latch-up. The contact pillar and/or the metal above the substrate contact can also serve as another form of heat sink.

Fig. 7(a3c) shows a top view of an electrical fuse element 198" according to yet another embodiment. The electrical fuse element 198" is similar to the one shown in Fig. 7(a1) except having a heat sink 195" in the cathode. The electrical fuse element 198" can, for example, be used as the resistive element 31a illustrated in Fig. 5(a). The electrical fuse element 198" includes a cathode 199", an anode 190", a body 191", and a heat sink 195". In one embodiment, the heat sink area can be only one side, instead of two sides to fit into small cell space, and/or the length can be longer or shorter. In another embodiment, the heat sink area can be a portion of anode or body in one side or two sides. In yet another embodiment, the length to width ratio of a heat sink area can be larger than 0.6 or larger than minimum requirement by design rules.

Fig. 7(a3d) shows a top view of an electrical fuse element 198"' according to yet another embodiment. The electrical fuse element 198"' is similar to the one shown in Fig. 7(a1) except a heater 195'" is created near the cathode. The electrical fuse element 198'" can, for example, be used as the resistive element 31a illustrated in Fig. 5(a). The electrical fuse element 198"' includes an anode 199"', a cathode 190"', a body 191"', and high resistance area 195"' which can serve as a heater. The high resistance area 195'" can generate more heat to assist programming the fuse element. In one embodiment, the heater can be an unsilicided polysilicon or unsilicided active region with a higher resistance than the silicided polysilicon or silicided active region, respectively. In another embodiment, the heater can be a single or a plurality of contact and/or via in serial to contribute more resistance and generate more heat along the programming path. In yet another embodiment, the heater can be a portion of high resistance interconnect to provide more heat to assist programming. The heater 195"" can be place to the cathode, anode, or body, in part or all of a fuse element. Active region 197'" has a substrate contact to reduce latch-up hazards. The contact pillar in the active region 197"' can also act as a heat sink.

Fig. 7(a3e) shows a top view of an electrical fuse element 298 according to yet another embodiment. The electrical fuse element 298 is similar to the one shown in Fig. 7(a1) but further includes an extended region 295 in a cathode portion. The electrical fuse element 298 can, for example, be used as the resistive element 31a illustrated in Fig. 5(a). The electrical fuse element 298 includes a cathode 299, an anode 290, a body 291, and an extended cathode region 295. In other embodiments, the extended cathode area can be on only one side of the body 291, for small cell size, and/or the length of the extended cathode structures can be longer or shorter. More generally, however, the extended cathode region 295 is referred to as an extended area. That is, the extended cathode region 295 is one example of an extended area. In another embodiment, the extended area can be a portion of anode or body in one side or two sides. In yet another embodiment, the length to width ratio of an extended area can be larger than 0.6. The extended area means any additional area longer than required by design rules and coupled to an anode, cathode, or body that has reduced or no current flowing therethrough to assist with programming.

Fig. 7(a3f) shows a top view of an electrical fuse element 298' with an extended area in a cathode portion according to another embodiment. The electrical fuse 298' has a cathode 299', an anode 290' and a body 291'. The cathode 299' has an extended cathode area 295' near to and on one or two sides of the body 291' to assist (e.g., accelerate) programming. The extended area 295' are pieces of fuse element that extend beyond nearest cathode and anode contacts and are longer than required by design rules. The anode contact 290' in the electrical fuse element 298' is also borderless, namely, the contact is wider than the underneath fuse element. In another embodiment, the cathode contact can be borderless and/or the anode portion can have extended area.

Fig. 7(a3g) shows a top view of an electrical fuse element 298" according to another embodiment. The electrical fuse 298" has a cathode contact 299", an anode 290" and a body 291". The cathode 299" has extended areas 295", and contacts 299" near to and on two sides of the body 291" to accelerate programming. The extended areas 295" are segments of fuse element that extend beyond the cathode or anode contact with reduced or substantially no current flowing through and/or are longer than required by design rules. The extended area 295" can have the length to width ratio in the current flowing path of larger than required by design rules, or larger than 0.6, for example. The anode 290" has a shared contact 296" to interconnect the fuse element 291" with an active region 297" in a single contact 296" with a piece of metal 293" on top. The extended area can be near to one side of the body 291" and/or attached to cathode or anode in other embodiment. In another embodiment, the extended area can be straight or bent more than once to save area. In yet another embodiment, the anode can have an extended area and/or the cathode can have a shared contact.

A heat sink can be used to create a temperature gradient to accelerate programming. The heat sink as shown in Figs. 7(a1), 7(a3a)-7(a3c) are for illustrative purposes. A heat sink can be a thin oxide area placed near, underneath, or above the anode, body, or cathode of a fuse element in one, two, three, four, or any sides to dissipate heat faster. A heat sink can be an extended area of the anode, body, or cathode of a fuse element to increase heat dissipation area. A heat sink can also be a single or a plurality of conductors coupled to (i.e., in contact or in proximity) the anode, body, or cathode of a fuse element to dissipate heat faster. A heat sink can also be a large area of anode or cathode with one or more contact/via to increase heat dissipation area. A heat sink can also be an active region and/or with at least one contact pillar built above an active region near the cathode, body, or anode of the fuse element to dissipate heat faster. In an OTP cell that has a shared contact, i.e., using a metal to interconnect MOS gate and active region in a single contact, can be considered as another embodiment of a heat sink for MOS gate to dissipate heat into the active region faster.

Extended areas as shown in Figs 7(a3e)-7(a3g) are portions of fuse element beyond a contact or via that is longer than required by design rules and has reduced or no substantial current flowing therethrough such that programming can be accelerated. An extended area (which can bend 45 or 90 degrees at least once and can include one or more components) can be placed to one, two, or any side of the anode, cathode, or body of a fuse element. An extended area can also act as a heat sink to dissipate more heat. Heat sink and extended area are based on two different physical properties to accelerate programming, though the embodiments in structure can be very similar. An extended area can act as a heat sink, but not the other way around. It should also be understood that the various embodiments can be used separate or in any combinations.

With a heat sink, the thermal conduction (i.e. heat loss) of a fuse element can be increased from 20% to 200% in some embodiments. Similarly, a heat generator can be used to create more heat to assist programming the fuse element. A heater, such as 83"' in Fig. 7(a2) or 195'" in Fig. 7(a3d), can usually be a high resistance area placed on or near the cathode, body, or anode in part or all of a fuse element to generate more heat. A heater can be embodied as a single or a plurality of unsilicided polysilicon, unsilicided active region, a single or a plurality of contact, via, or combined, or a single or a plurality of segment of high resistance interconnect in the programming path. The resistance of the heat generator can be from 8Ω to 200Ω, or more desirably from 20Ω to 100Ω, in some embodiments.

The fuse element with heat sink, heat generator, or extended area can be made of polysilicon, silicided polysilicon, silicide, polymetal, metal, metal alloy, metal gate, local interconnect, metal-0, thermally isolated active region, or CMOS gate, etc. There are many variations or combinations of variations and yet equivalent embodiments of heat sinks to dissipate heat, heat generators to provide more heat, and/or extended area to assist programming and that they are all within the scope of this invention.

Fig. 7(a4) shows a top view of an electrical fuse element 98' according to another embodiment. The electrical fuse element 98' is similar to the one shown in Fig. 7(a1) except the fuse element has at least one notch in the body to assist programming. More generally, a target portion of the body 91' can be made formed with less area (e.g., thinner), such as a notch. The electrical fuse element 98' can, for example, be used as the resistive element 31a illustrated in Fig. 5(a). The electrical fuse element 98' can include an anode 99', a cathode 90', and a body 91'. The body 91' has at least a notch 95' so that the fuse element can be easily broken during programming

Fig. 7(a5) shows a top view of an electrical fuse element 98" according to another embodiment. The electrical fuse element 98" is similar to the one shown in Fig. 7(a1) except the fuse element is part NMOS and part PMOS metal gates. The electrical fuse element 98" can, for example, be used as the resistive element 31a illustrated in Fig. 5(a). The electrical fuse element 98" can include an anode 99", a cathode 90", and bodies 91" and 93" fabricated from PMOS and NMOS metal gates, respectively. By using different types of metals in the same fuse element, the thermal expansion can create a large stress to rupture the fuse when the temperature is raised during programming.

The OTP elements shown in Figs 7(a1)-7(a2), 7(a3a)-7(a3g), 7(a4) and 7(a5) are only to illustrate certain embodiments. As denoted, the OTP elements can be built from any interconnects, including but not limited to polysilicon, silicided polysilicon, silicide, local interconnect, polymetal, metal, metal alloy, metal gate, thermally isolative active region, CMOS gate, or combinations thereof. Polymetal is a sandwich structure of metal-nitride-polysilicon, (i.e. W/WNx/Si) that can be used to reduce the resistance of polysilicon. The OTP elements can be N type, P type, or part N and part P type. Each of the OTP elements can have an anode, a cathode, and at least one body. The anode or cathode contacts can be no more than 2 for polysilicon/polymetal/local interconnect, and can be no more than 4 for metal fuse, preferably. The anode or cathode contact can be only one (1) in other embodiment. The contact size can be larger than at least one contact outside of the OTP memory array. The contact enclosure can be smaller than at least one contact enclosure outside of the OTP memory array. In another embodiment, the enclosure can be negative, namely, the contact is wider than the underneath figure, the so-called borderless contact. The length to width ratio in the body can be between 0.5-8, or more particular 2-6 in some embodiments, for polysilicon/local interconnect/polymetal/metal gate, or in the case of metal even larger than 10 for metal, for example. There are many variations or combinations of embodiments in part or all that can be considered equivalent embodiments.

Polysilicon used to define CMOS gates or as interconnect in a high-K/metal-gate CMOS process can also be used as OTP elements. The fuse element can be P type, N type, or part N and part P type if applicable. Particularly, the after/before resistance ratio can be enhanced for those fuse elements that have P+ and N+ implants to create a diode after being programmed, such as polysilicon, polymetal, thermally isolated active region, or gate of a high-K/metal-gate CMOS. For example, if a metal-gate CMOS has a sandwich structure of polysilicon between metal alloy layers, the metal alloy layers may be blocked by masks generated from layout database to create a diode in the fuse elements. In SOI or SOI-like processes, a fuse element can also be constructed from a thermally isolated active region such that the fuse element can be implanted with N+, P+, or part N+ and part P+ in each end of the active region. If a fuse element is partly implanted with N+ and P+, the fuse element can behave like a reverse-biased diode, such as when silicide on top is depleted after being programmed. In one embodiment, if there is no silicide on top of active regions, an OTP element can also be constructed from an isolated active region with part N+ and part P+ to act as a diode for breakdown in forward or reverse biased conditions. Using isolated active region to construct an OTP element, the OTP element can be merged with part of the program-selector diode in one single active island to save area.

In some processing technologies that can offer Local Interconnect, local interconnect can be used as part or all of an OTP element. Local interconnect, also called as metal0 (M0), is a by-product of a salicide process that has the capability to interconnect polysilicon or MOS gate with an active region directly. In advanced MOS technologies beyond 28nm, the scaling along the silicon surface dimensions is much faster than scaling in the height. As a consequence, the aspect ratio of CMOS gate height to the channel length is very large such that making contacts between metal 1 and source/drain or CMOS gate very expensive in terms of device area and cost. Local interconnect can be used as an intermediate interconnect between source/drain to CMOS gate, between CMOS gate to metal1, or between source/drain to metal1 in one or two levels The local interconnects, CMOS gate, or combination can be used as an OTP element in one embodiment. The OTP element and one terminal of the program-selector diode can be connected directly through local interconnect without needing any contacts to save area in another embodiment.

Those skilled in the art understand that the above discussions are for illustrative purposes and that there are many variations and equivalents in constructing electrical fuse (including anti-fuses), or program selectors in CMOS processes,

Figs. 7(b) and 7(c) show top views of P+/N well diodes constructed with different embodiments of isolation and fuse elements. Without isolation, P+ and N+ active regions would be shorted together by silicide grown on top. The isolation can be provided by STI, dummy CMOS gate, SBL, or some combination thereof from one to four (1-4) or any sides or between cells. The P+ and N+ active regions that act as P and N terminals of the diodes are sources or drains of CMOS devices. Both the P+ and N+ active regions reside in an N well, which can be the same N well to house PMOS in standard CMOS processes. The N+ active region of the diodes in multiple cells can be shared, though for simplicity Figs. 7(b) and 7(c) show only one N+ active region for one P+ active region.

Fig. 7(b) shows a top view of one embodiment of an electrical fuse cell 70 having a P+/N well diode with an abutted contact. Active regions 73 and 74, which are isolated by an STI 79, are covered by a P+ implant 77 and an N+ implant (the complement of the P+ implant 77), respectively, to constitute the P and N terminals of the diode 70. Both of the active regions 73 and 74 reside in an N well 75, the same N well can be used to house PMOS in standard CMOS processes. A fuse element 72 is coupled to the P+ active region 73 through a metal 76 in a single contact 71. This contact 71 is quite different from the contacts in conventional ways where a contact can be used to connect a fuse element with a metal and then another contact is used to connect the metal with a P+ active region. By connecting a fuse element directly to an active region through a metal in a single contact, the cell area can be reduced substantially. The abutted contact can be larger than a regular contact and, more particularly, can be a large rectangular contact that has about twice the area of a regular contact in a CMOS process. This embodiment for a fuse element can be constructed by a CMOS gate, including polysilicon, silicided polysilicon, polymetal, local interconnect, or non-aluminum metal CMOS gate, that allows an abutted contact.

Fig. 7(c) shows a top view of yet another embodiment of a fuse cell 70" that has a dummy MOS gate 78" providing isolation between P+/N+ in N well as two terminals of a diode and an electrical fuse element 72". An active region 71" is divided into an upper active regions 73" and a lower active region 74" by a dummy MOS gate 78". The upper active region 73" can be covered by a P+ implant 77" while the lower active region 74" can be covered by an N+ implant (the complement of the P+ implant 77"). The active regions 73" and 74" constitute the P and N terminals of the diode in the cell 70". The polysilicon 78" provides isolation between the P+/N+ of the diode in the cell 70" and can be tied to a fixed bias. The polysilicon 78" is a dummy MOS gate fabricated in standard CMOS processes and can be a metal gate in advanced metal-gate CMOS processes. The width of the dummy MOS gate can be close to the minimum gate width of a CMOS technology. In one embodiment, the width of the dummy MOS gate can be less than twice the minimum gate width of a CMOS technology. The dummy MOS gate can also be created from a thicker gate oxide than that in the core devices to sustain higher voltage. The active region 71" resides in an N well 75", the same N well that can be used to house PMOS in standard CMOS processes. A fuse element 72" can be coupled to the P+ active region 73" through a metal 76" in one end (through contacts 75"-2 and 75"-3) and to a high voltage supply line V+ in the other end (through contact 75"-1). The N+ region 74" is coupled to another voltage supply line V- through another contact 75"-4. At least one of the contacts 75"-1, 2, 3, 4 can be larger than at least one contacts outside of the memory array to reduce the contact resistance in one embodiment. When high and low voltages are applied to V+ and V-, respectively, a high current can flow through the fuse element 72" to program the fuse element 72" into a high resistance state accordingly.

Fig. 8 shows a processor system 700 according to one embodiment. The processor system 700 can include a programmable resistive device 744, such as in a cell array 742, in memory 740, according to one embodiment. The processor system 700 can, for example, pertain to a computer system. The computer system can include a Central Process Unit (CPU) 710, which communicate through a common bus 715 to various memory and peripheral devices such as I/O 720, hard disk drive 730, CDROM 750, memory 740, and other memory 760. Other memory 760 is a conventional memory such as SRAM, DRAM, or flash, typically interfaces to CPU 710 through a memory controller. CPU 710 generally is a microprocessor, a digital signal processor, or other programmable digital logic devices. Memory 740 is preferably constructed as an integrated circuit, which includes the memory array 742 having at least one programmable resistive device 744. The memory 740 typically interfaces to CPU 710 through a memory controller. If desired, the memory 740 may be combined with the processor, for example CPU 710, in a single integrated circuit.

The invention can be implemented in a part or all of an integrated circuit in a Printed Circuit Board (PCB), or in a system. The programmable resistive device can be fuse, anti-fuse, or emerging nonvolatile memory. The fuse can be silicided or non-silicided polysilicon fuse, thermally isolated active-region fuse, local interconnect fuse, metal fuse, contact fuse, via fuse, or fuse constructed from CMOS gates. The anti-fuse can be a gate-oxide breakdown anti-fuse, contact or via anti-fuse with dielectrics in-between. The emerging nonvolatile memory can be Magnetic RAM (MRAM), Phase Change Memory (PCM), Conductive Bridge RAM (CBRAM), or Resistive RAM (RRAM). Though the program mechanisms are different, their logic states can be distinguished by different resistance values.

The above description and drawings are only to be considered illustrative of exemplary embodiments, which achieve the features and advantages of the present invention. Modifications and substitutions of specific process conditions and structures can be made without departing from the scope of the present invention.

The many features and advantages of the present invention are apparent from the written description and, thus, it is intended by the appended claims to cover all such features and advantages of the invention. Further, since numerous modifications and changes will readily occur to those skilled in the art, it is not desired to limit the invention to the exact construction and operation as illustrated and described. Hence, all suitable modifications and equivalents may be resorted to as falling within the scope of the invention as defined by the appended claims.

## Claims

1. A method of programming One-Time Programmable, OTP, memory (740), comprising:
providing a plurality of OTP cells (742), at least one of the OTP cells (30) including at least:
an OTP element (30a) including at least one electrical fuse having a first terminal coupled to a first supply voltage line, and
a selector (30b) coupled to the OTP element with an enable signal coupled to a second supply voltage line;
one-time programming the at least one OTP cell (30) into a different logic state by applying a plurality of voltage or current pulses to the first and the second supply voltage lines to turn on the selector (30b) and to thereby change the fuse resistance progressively; and
subsequently one time programming another OTP cell of the plurality of OTP cells by applying a program voltage in one pulse only, the program voltage being based on said one-time programming of the at least one OTP cell.

2. A method of programming One-Time Programmable, OTP, memory (740), as recited in claim 1, wherein one-time programming of the at least one OTP cell (30) comprises:
(a) obtaining a destructive program current that would cause the at least one OTP cell to undergo drastic resistance changes; and
(b) limiting the program current below the destructive program current.

3. A method of programming One-Time Programmable, OTP, memory (740), as recited in claim 1, wherein the one-time programming of the at least one OTP cell (30), comprises:
(a) programming a portion of OTP memory using initially a low program voltage and gradually incrementally increasing the program voltage until all OTP cells in that portion of OTP memory are programmed and verified correctly to determine a low bound of the program voltage; and
(b) incrementally increasing the program voltage and then programing the same portion of OTP memory until an excessive voltage is identified where at least one OTP cell, either programmed or not, is verified with errors to determine a high bound of the program voltage.

4. A method of programming One-Time Programmable , OTP, memory (740) as recited in claim 1, wherein the selector (30b) is a diode (32') that has a dummy gate (39') to isolate the first terminal from the second terminal or a MOS that can be turned on through the channel or the source/drain junction.

5. A method of programming One-Time Programmable, OTP, memory (740) as recited in claim 1, wherein the selector has at least one diode (32) including at least a first active region (33) and a second active region (37) isolated from the first active region, the first active region having a first type of dopant and a second active region having a second type of dopant, the first active region providing a first terminal of the diode, the second active region providing a second terminal of the diode, both the first and second active regions residing in a common CMOS well or on an isolated substrate, the at least one active regions being fabricated from sources or drains of CMOS devices.

6. A method of programming One-Time Programmable , OTP, memory (740) as recited in claim 5, wherein at least one shallow trench isolation (36) isolates the first and second terminals of the diode and/or adjacent OTP cells.

7. A method of programming One-Time Programmable , OTP, memory (740) as recited in claim 1, wherein the selector (32", 832, 932, 45) is built on a thermally isolated substrate or on a 3D fin structure.

8. A method of programming One-Time Programmable, OTP, memory (740) as recited in claim 1, wherein the electrical fuse (88", 88"', 198', 198", 198"') includes at least a portion of a heat sink, heat generator, or extended area.

9. A method of programming OTP memory (740) as recited in claim 1, wherein the one-time programming of the at least one OTP cell (30) comprises:
obtaining a critical program current that would cause the at least one OTP cell to undergo a negative resistance change; and
limiting the program current below the critical program current.

10. A method of programming OTP memory (740) as recited in claim 3, wherein the one-time programming of the at least one OTP cell (30) comprises:
changing the duration of the voltage or current pulses; and
obtaining the lower bound and upper bound of the program voltage, the obtaining comprising (i) programming a portion of the OTP memory using initially a low program voltage and gradually incrementally increasing the program voltage until all the OTP cells in the portion of OTP memory are programmed and read verified correctly, so as to determine the lower bound of the program voltage; and (ii) incrementally increasing the program voltage and program the portion of the OTP memory until an excessive voltage is identified where at least one OTP cell, either programmed or not, is read with an error, so as to determine an upper bound of the program voltage.

11. A method of programming OTP memory (740) as recited in claim 1, wherein an OTP cell current of a programmed or unprogrammed OTP cell (30) can be determined by:
applying, in a program mode, a voltage to a program voltage pad VDDP lower enough that can not program the OTP cell;
preventing the program voltage VDDP from supplying currents to an OTP macro other than the OTP memory array;
turning on the selector of the OTP cell to measure the OTP cell current; and
measuring the current flowing through the program voltage pad VDDP.

12. A method of programming OTP memory (740) as recited in claim 11, wherein the one-time programming of the at least one OTP cell (30) comprises:
programming a portion of OTP memory using initially a low program voltage and gradually incrementally increasing the program voltage until all OTP cells in that portion of OTP memory are programmed and their cell currents are below a predetermined value to determine a lower bound of the program voltage; and
incrementally increasing the program voltage and then programming the same portion of OTP memory until an excessive voltage is identified where at least one programmed OTP cell has the cell current above a predetermined value or at least one un-programmed OTP cell has the cell current below another predetermined value, to determine an upper bound of the program voltage.

13. A method of programming OTP memory (740) as recited in claim 12, wherein the one-time programming of the at least one OTP cell (30) comprises:
changing the duration of voltage or current pulses for programming; and
obtaining lower bound and upper bound of the program voltage, the obtaining comprising (i) programming a portion of OTP memory using initially a low program voltage and gradually incrementally increasing the program voltage until all OTP cells in that portion of OTP memory are programmed and their cell currents are below a predetermined value to determine a lower bound of the program voltage; and (ii) incrementally increasing the program voltage and programming the same portion of OTP memory until an excessive voltage is identified where at least one programmed OTP cell has the cell current above a predetermined value or at least one un-programmed OTP cell has the cell current below another predetermined value, to determine an upper bound of the program voltage.

14. A method of programming OTP memory (740) as recited in claim 12, wherein the method comprises one-time programming another OTP cell of the plurality of OTP cells by applying a voltage between the lower and upper bounds of the program voltage in one pulse.

15. A method of programming as recited in claim 1, wherein the at least one selector comprises a MOS device that can be turned on in a junction diode (30b) or in a channel of the MOS device for programming or reading the OTP cells.

16. A method of programming One-Time Programmable, OTP, memory (740) as recited in claim 1, comprising:
programming at least a first portion of the OTP memory using initially a low program voltage and gradually incrementally increasing the program voltage until all the OTP cells in the first portion of the OTP memory are programmed and verified correctly, so as to determine a lower bound of the program voltage;
incrementally increasing the program voltage and then programming the first portion or a second portion of the OTP memory until an excessive voltage is identified where at least one OTP cell, either programmed or not, is verified with an error, so as to determine an upper bound of the program voltage; and
recording the lower and upper bounds of the program voltage for subsequent use in programming a third portion of the OTP memory or another OTP memory, using a voltage between the lower and upper bounds in a single pulse.

17. A method of programming as recited in claim 16, wherein the method comprises:
subsequently programming the third portion of the OTP memory by applying the voltage between the lower and upper bounds of the program voltage in a single pulse to at least one OTP cell in the OTP memory.

18. A method of programming as recited in claim 16, wherein the method comprises:
subsequently programming at least a portion of the another OTP memory by applying the voltage between the lower and upper bounds of the program voltage in a single pulse to at least one OTP cell in the another OTP memory.

19. A One-Time Programmable, OTP, memory (740), comprising:
a plurality of OTP cells (742), each of the OTP cells (30) including at least:
an OTP element (30a) including at least an electrical fuse coupled to a first supply voltage line; and
a selector (30b) incoupled to the OTP element and to a second supply voltage line,
wherein the OTP memory (740) is configured to program a first of the OTP cells by applying a plurality of voltage or current pulses to the first and the second supply voltage lines to turn on the selector and to thereby change a fuse 10 resistance progressively and thereby establish an upper and a lower voltage, and
wherein the OTP memory (740) is further configured to program a second of the OTP cells in one pulse by applying a program voltage between the lower and the upper voltage levels.

## Patentansprüche

1. Verfahren zum Programmieren eines One-Time Programmable, OTP, Speichers (740),
umfassend:
Bereitstellen einer Vielzahl von OTP-Zellen (742), wobei mindestens eine der OTP-Zellen (30) mindestens umfasst:
ein OTP-Element (30a), das mindestens eine elektrische Sicherung mit einem ersten Anschluss umfasst, der mit einer ersten Versorgungsspannungsleitung gekoppelt ist, und
einen Selektor (30b), der an das OTP-Element mit einem Freigabesignal gekoppelt ist, das an eine zweite Versorgungsspannungsleitung gekoppelt ist;
einmaliges Programmieren der mindestens einen OTP-Zelle (30) in einen anderen logischen Zustand durch Anlegen einer Vielzahl von Spannungs- oder Strompulsen an die erste und die zweite Versorgungsspannungsleitung, um den Selektor (30b) einzuschalten und dadurch den Sicherungswiderstand progressiv zu ändern; und
anschließendes einmaliges Programmieren einer anderen OTP-Zelle der Vielzahl von OTP-Zellen durch Anlegen einer Programmierspannung in nur einem Puls, wobei die Programmierspannung auf dem einmaligen Programmieren der mindestens einen OTP-Zelle basiert.

2. Verfahren zum Programmieren eines One-Time Programmable, OTP, Speichers (740) gemäß Anspruch 1, wobei das einmalige Programmieren der mindestens einen OTP-Zelle (30) umfasst:
(a) Erhalten eines destruktiven Programmierstroms, der bewirken würde, dass die mindestens eine OTP-Zelle drastische Widerstandsänderungen erfährt; und
(b) Begrenzen des Programmierstroms unter den destruktiven Programmierstrom.

3. Verfahren zum Programmieren eines One-Time Programmable, OTP, Speichers (740) gemäß Anspruch 1, wobei das einmalige Programmieren der mindestens einen OTP-Zelle (30) umfasst:
(a) Programmieren eines Teils des OTP-Speichers unter Verwendung einer anfänglich niedrigen Programmierspannung und graduelles inkrementelles Erhöhen der Programmierspannung, bis alle OTP-Zellen in diesem Teil des OTP-Speichers korrekt programmiert und verifiziert sind, um eine untere Grenze der Programmierspannung zu bestimmen; und
(b) inkrementelles Erhöhen der Programmierspannung und anschließendes Programmieren desselben Teils des OTP-Speichers, bis eine übermäßige Spannung festgestellt wird, wobei mindestens eine OTP-Zelle, ob programmiert oder nicht, mit Fehlern verifiziert wird, um eine obere Grenze der Programmierspannung zu bestimmen.

4. Verfahren zum Programmieren eines One-Time Programmable, OTP, Speichers (740) gemäß Anspruch 1, wobei der Selektor (30b) eine Diode (32') ist, die ein Dummy-Gate (39') hat, um den ersten Anschluss von dem zweiten Anschluss zu isolieren, oder ein MOS, das über den Kanal oder den Source/Drain-Übergang eingeschaltet werden kann.

5. Verfahren zum Programmieren eines One-Time Programmable, OTP, Speichers (740) gemäß Anspruch 1, wobei der Selektor mindestens eine Diode (32) hat, die mindestens einen ersten aktiven Bereich (33) und einen zweiten aktiven Bereich (37) hat, der von dem ersten aktiven Bereich isoliert ist, wobei der erste aktive Bereich einen ersten Typ von Dotierstoff und ein zweiter aktiver Bereich einen zweiten Typ von Dotierstoff hat, wobei der erste aktive Bereich einen ersten Anschluss der Diode bereitstellt, der zweite aktive Bereich einen zweiten Anschluss der Diode bereitstellt, wobei sowohl der erste als auch der zweite aktive Bereich in einer gemeinsamen CMOS-Topf oder auf einem isolierten Substrat angeordnet sind, wobei der mindestens eine aktive Bereich aus Sources oder Drains von CMOS-Vorrichtungen hergestellt ist.

6. Verfahren zum Programmieren eines One-Time Programmable, OTP, Speichers (740) gemäß Anspruch 5, wobei mindestens eine flache Grabenisolation (36) die ersten und zweiten Anschlüsse der Diode und/oder benachbarte OTP-Zellen isoliert.

7. Verfahren zum Programmieren eines One-Time Programmable, OTP, Speichers (740) gemäß Anspruch 1, wobei der Selektor (32", 832, 932, 45) auf einem thermisch isolierten Substrat oder auf einer 3D-Lamellenstruktur aufgebaut ist.

8. Verfahren zum Programmieren eines One-Time Programmable, OTP, Speichers (740) gemäß Anspruch 1, wobei die elektrische Sicherung (88", 88"', 198', 198", 198"') mindestens einen Teil einer Wärmesenke, eines Wärmeerzeugers oder eines erweiterten Bereichs umfasst.

9. Verfahren zum Programmieren eines OTP-Speichers (740) gemäß Anspruch 1, wobei das einmalige Programmieren der mindestens einen OTP-Zelle (30) umfasst:
Erhalten eines kritischen Programmierstroms, der bewirken würde, dass die mindestens eine OTP-Zelle eine negative Widerstandsänderung erfährt; und
Begrenzen des Programmierstroms unter den kritischen Programmierstrom.

10. Verfahren zum Programmieren eines OTP-Speichers (740) gemäß Anspruch 3, wobei das einmalige Programmieren der mindestens einen OTP-Zelle (30) umfasst:
Ändern der Dauer der Spannungs- oder Strompulse; und
Erhalten der unteren Grenze und der oberen Grenze der Programmierspannung, wobei das Erhalten umfasst:
(i) Programmieren eines Teils des OTP-Speichers unter Verwendung einer anfänglich niedrigen Programmierspannung und graduelles inkrementelles Erhöhen der Programmierspannung, bis alle OTP-Zellen in dem Teil des OTP-Speichers korrekt programmiert und leseverifiziert sind, um so die untere Grenze der Programmierspannung zu bestimmen; und
(ii) inkrementelles Erhöhen der Programmierspannung und Programmieren des Teils des OTP-Speichers, bis eine übermäßige Spannung identifiziert wird, wobei mindestens eine OTP-Zelle, entweder programmiert oder nicht, mit einem Fehler gelesen wird, um so eine obere Grenze der Programmierspannung zu bestimmen.

11. Verfahren zum Programmieren eines OTP-Speichers (740) gemäß Anspruch 1, wobei ein OTP-Zellenstrom einer programmierten oder nicht programmierten OTP-Zelle (30) bestimmt werden kann durch:
Anlegen, in einem Programmiermodus, einer Spannung an einen Programmierspannungs-Pad VDDP, die niedrig genug ist, dass die OTP-Zelle nicht programmiert werden kann;
Verhindern, dass die Programmierspannung VDDP Ströme an ein anderes OTP-Makro als das OTP-Speicherfeld liefert;
Einschalten des Selektors der OTP-Zelle, um den OTP-Zellenstrom zu messen; und
Messen des Stroms, der durch das Programmierspannungspad VDDP fließt.

12. Verfahren zum Programmieren eines OTP-Speichers (740) gemäß Anspruch 11, wobei das einmalige Programmieren der mindestens einen OTP-Zelle (30) umfasst:
Programmieren eines Teils des OTP-Speichers unter Verwendung einer anfänglich niedrigen Programmierspannung und graduelles inkrementelles Erhöhen der Programmierspannung, bis alle OTP-Zellen in diesem Teil des OTP-Speichers programmiert sind und ihre Zellenströme unter einem vorbestimmten Wert liegen, um eine untere Grenze der Programmierspannung zu bestimmen; und
inkrementelles Erhöhen der Programmierspannung und anschließendes Programmieren desselben Teils des OTP-Speichers, bis eine übermäßige Spannung erkannt wird, bei der mindestens eine programmierte OTP-Zelle den Zellenstrom über einem vorbestimmten Wert oder mindestens eine nicht programmierte OTP-Zelle den Zellenstrom unter einem anderen vorbestimmten Wert hat, um eine obere Grenze der Programmierspannung zu bestimmen.

13. Verfahren zum Programmieren eines OTP-Speichers (740) gemäß Anspruch 12, wobei das einmalige Programmieren der mindestens einen OTP-Zelle (30) umfasst:
Ändern der Dauer von Spannungs- oder Strompulsen zum Programmieren; und
Erhalten der unteren Grenze und der oberen Grenze der Programmierspannung, wobei das Erhalten umfasst:
(i) Programmieren eines Teils des OTP-Speichers unter Verwendung einer anfänglich niedrigen Programmierspannung und graduelles inkrementelles Erhöhen der Programmierspannung, bis alle OTP-Zellen in diesem Teil des OTP-Speichers programmiert sind und ihre Zellenströme unter einem vorbestimmten Wert liegen, um eine untere Grenze der Programmierspannung zu bestimmen; und
(ii) inkrementelles Erhöhen der Programmierspannung und Programmieren desselben Teils des OTP-Speichers, bis eine übermäßige Spannung identifiziert wird, bei der mindestens eine programmierte OTP-Zelle den Zellenstrom über einem vorbestimmten Wert hat oder mindestens eine nicht programmierte OTP-Zelle den Zellenstrom unter einem anderen vorbestimmten Wert hat, um eine obere Grenze der Programmierspannung zu bestimmen.

14. Verfahren zum Programmieren eines OTP-Speichers (740) gemäß Anspruch 12, wobei das Verfahren das einmalige Programmieren einer anderen OTP-Zelle aus der Vielzahl von OTP-Zellen durch Anlegen einer Spannung zwischen der unteren und der oberen Grenze der Programmierspannung in einem Puls umfasst.

15. Verfahren zum Programmieren gemäß Anspruch 1, wobei der mindestens eine Selektor eine MOS-Vorrichtung umfasst, die in einer Übergangsdiode (30b) oder in einem Kanal der MOS-Vorrichtung zum Programmieren oder Lesen der OTP-Zellen eingeschaltet werden kann.

16. Verfahren zum Programmieren von One-Time Programmable, OTP, Speicher (740) gemäß Anspruch 1, umfassend:
Programmieren mindestens eines ersten Teils des OTP-Speichers unter Verwendung einer anfänglich niedrigen Programmierspannung und graduelles inkrementelles Erhöhen der Programmierspannung, bis alle OTP-Zellen im ersten Teil des OTP-Speichers korrekt programmiert und verifiziert sind, um so eine untere Grenze der Programmierspannung zu bestimmen;
inkrementelles Erhöhen der Programmierspannung und anschließendes Programmieren des ersten Teils oder eines zweiten Teils des OTP-Speichers, bis eine übermäßige Spannung identifiziert wird, wobei mindestens eine OTP-Zelle, ob programmiert oder nicht, mit einem Fehler verifiziert wird, um so eine obere Grenze der Programmierspannung zu bestimmen; und
Aufzeichnen der unteren und oberen Grenzen der Programmierspannung zur späteren Verwendung beim Programmieren eines dritten Teils des OTP-Speichers oder eines anderen OTP-Speichers unter Verwendung einer Spannung zwischen der unteren und oberen Grenze in einem einzigen Puls.

17. Verfahren zum Programmieren gemäß Anspruch 16, wobei das Verfahren umfasst:
anschließendes Programmieren des dritten Teils des OTP-Speichers durch Anlegen der Spannung zwischen der unteren und der oberen Grenze der Programmierspannung in einem einzigen Puls an mindestens eine OTP-Zelle im OTP-Speicher.

18. Verfahren zum Programmieren gemäß Anspruch 16, wobei das Verfahren umfasst:
anschließendes Programmieren mindestens eines Teils des anderen OTP-Speichers durch Anlegen der Spannung zwischen der unteren und der oberen Grenze der Programmierspannung in einem einzigen Puls an mindestens eine OTP-Zelle in dem anderen OTP-Speicher.

19. One-Time Programmable, OTP, Speicher (740), umfassend:
eine Vielzahl von OTP-Zellen (742), wobei jede der OTP-Zellen (30) mindestens umfasst:
ein OTP-Element (30a), dass mindestens eine elektrische Sicherung umfasst, die mit einer ersten Versorgungsspannungsleitung gekoppelt ist; und
einen Selektor (30b), der an das OTP-Element und an eine zweite Versorgungsspannungsleitung gekoppelt ist,
wobei der OTP-Speicher (740) ausgebildet ist, eine erste der OTP-Zellen durch Anlegen einer Vielzahl von Spannungs- oder Strompulsen an die erste und die zweite Versorgungsspannungsleitung zu programmieren, um den Selektor einzuschalten und dadurch einen Sicherungswiderstand progressiv zu ändern und dadurch eine obere und eine untere Spannung aufzubauen, und wobei der OTP-Speicher (740) ferner ausgebildet ist, eine zweite der OTP-Zellen in einem Puls durch Anlegen einer Programmierspannung zwischen dem unteren und dem oberen Spannungslevel zu programmieren.

## Revendications

1. Procédé de programmation de mémoire (740) programmable une seule fois, OTP, comprenant le fait :
de fournir une pluralité de cellules OTP (742), au moins l'une des cellules OTP (30) comportant au moins :
un élément OTP (30a) comportant au moins un fusible électrique ayant une première borne couplée à une première ligne de tension d'alimentation, et
un sélecteur (30b) couplé à l'élément OTP avec un signal d'activation couplé à une deuxième ligne de tension d'alimentation ;
de programmer une seule fois l'au moins une cellule OTP (30) dans un état logique différent en appliquant une pluralité d'impulsions de tension ou de courant aux première et deuxième lignes de tension d'alimentation pour mettre sous tension le sélecteur (30b) et pour changer ainsi la résistance de fusible progressivement ; et
de programmer une seule fois, ultérieurement, une autre cellule OTP de la pluralité de cellules OTP en appliquant une tension de programme en une seule impulsion, la tension de programme étant basée sur ladite programmation une seule fois de l'au moins une cellule OTP.

2. Procédé de programmation de mémoire (740) programmable une seule fois, OTP, selon la revendication 1, dans lequel la programmation une seule fois de l'au moins une cellule OTP (30) comprend le fait :
(a) d'obtenir un courant de programme destructeur qui amènerait l'au moins une cellule OTP à subir des changements de résistance radicaux ; et
(b) de limiter le courant de programme en dessous du courant de programme destructeur.

3. Procédé de programmation de mémoire (740) programmable une seule fois, OTP, selon la revendication 1, dans lequel la programmation une seule fois de l'au moins une cellule OTP (30) comprend le fait :
(a) de programmer une partie de la mémoire OTP en utilisant initialement une tension de programme basse et en augmentant progressivement par incréments la tension de programme jusqu'à ce que toutes les cellules OTP dans cette partie de la mémoire OTP soient programmées et vérifiées correctement pour déterminer une limite basse de la tension de programme ; et
(b) d'augmenter par incréments la tension de programme et de programmer ensuite la même partie de la mémoire OTP jusqu'à ce qu'une tension excessive soit identifiée où au moins une cellule OTP, programmée ou non, est vérifiée avec des erreurs pour déterminer une limite haute de la tension de programme.

4. Procédé de programmation de mémoire (740) programmable une seule fois, OTP, selon la revendication 1, dans lequel le sélecteur (30b) est une diode (32') qui a une grille factice (39') pour isoler la première borne de la deuxième borne ou un MOS qui peut être mis sous tension via le canal ou la jonction source/drain.

5. Procédé de programmation de mémoire (740) programmable une seule fois, OTP, selon la revendication 1, dans lequel le sélecteur a au moins une diode (32) comportant au moins une première région active (33) et une deuxième région active (37) isolée de la première région active, la première région active ayant un premier type de dopant et une deuxième région active ayant un deuxième type de dopant, la première région active fournissant une première borne de la diode, la deuxième région active fournissant une deuxième borne de la diode, les première et deuxième régions actives se trouvant toutes deux dans un puits CMOS commun ou sur un substrat isolé, l'au moins une région active étant fabriquée à partir de sources ou de drains de dispositifs CMOS.

6. Procédé de programmation de mémoire (740) programmable une seule fois, OTP, selon la revendication 5, dans lequel au moins une isolation à tranchées peu profondes (36) isole les première et deuxième bornes de la diode et/ou des cellules OTP adjacentes.

7. Procédé de programmation de mémoire (740) programmable une seule fois, OTP, selon la revendication 1, dans lequel le sélecteur (32", 832, 932, 45) est construit sur un substrat thermiquement isolé ou sur une structure à ailettes 3D.

8. Procédé de programmation de mémoire (740) programmable une seule fois, OTP, selon la revendication 1, dans lequel le fusible électrique (88", 88"', 198', 198", 198'") comporte au moins une partie d'un dissipateur de chaleur, d'un générateur de chaleur ou d'une zone étendue.

9. Procédé de programmation de mémoire OTP (740) selon la revendication 1, dans lequel la programmation une seule fois de l'au moins une cellule OTP (30) comprend le fait :
d'obtenir un courant de programme critique qui amènerait l'au moins une cellule OTP à subir un changement de résistance négatif ; et
de limiter le courant de programme en dessous du courant de programme critique.

10. Procédé de programmation de mémoire OTP (740) selon la revendication 3, dans lequel la programmation une seule fois de l'au moins une cellule OTP (30) comprend le fait :
de changer la durée des impulsions de tension ou de courant ; et
d'obtenir la limite inférieure et la limite supérieure de la tension de programme, l'obtention comprenant (i) la programmation d'une partie de la mémoire OTP en utilisant initialement une tension de programme basse et en augmentant progressivement par incréments la tension de programme jusqu'à ce que toutes les cellules OTP dans la partie de la mémoire OTP soient programmées et lues vérifiées correctement, de manière à déterminer la limite inférieure de la tension de programme ; et (ii) l'augmentation par incréments de la tension de programme et la programmation de la partie de la mémoire OTP jusqu'à ce qu'une tension excessive soit identifiée où au moins une cellule OTP, programmée ou non, est lue avec une erreur, de manière à déterminer une limite supérieure de la tension de programme.

11. Procédé de programmation de mémoire OTP (740) selon la revendication 1, dans lequel un courant de cellule OTP d'une cellule OTP programmée ou non programmée (30) peut être déterminé :
en appliquant, dans un mode programme, une tension à un plot de tension de programme VDDP suffisamment inférieure pour ne pas pouvoir programmer la cellule OTP ;
en empêchant la tension de programme VDDP de fournir des courants à une macro OTP autre que la matrice mémoire OTP ;
en mettant sous tension le sélecteur de la cellule OTP pour mesurer le courant de cellule OTP ; et
en mesurant le courant circulant à travers le plot de tension de programme VDDP.

12. Procédé de programmation de mémoire OTP (740) selon la revendication 11, dans lequel la programmation une seule fois de l'au moins une cellule OTP (30) comprend le fait :
de programmer une partie de la mémoire OTP en utilisant initialement une tension de programme basse et en augmentant progressivement par incréments la tension de programme jusqu'à ce que toutes les cellules OTP dans cette partie de la mémoire OTP soient programmées et leurs courants de cellule soient inférieurs à une valeur prédéterminée pour déterminer une limite inférieure de la tension de programme ; et
d'augmenter par incréments la tension de programme et de programmer ensuite la même partie de la mémoire OTP jusqu'à ce qu'une tension excessive soit identifiée où au moins une cellule OTP programmée a le courant de cellule supérieur à une valeur prédéterminée ou au moins une cellule OTP non programmée a le courant de cellule inférieur à une autre valeur prédéterminée, pour déterminer une limite supérieure de la tension de programme.

13. Procédé de programmation de mémoire OTP (740) selon la revendication 12, dans lequel la programmation une seule fois de l'au moins une cellule OTP (30) comprend le fait :
de changer la durée des impulsions de tension ou de courant pour la programmation ; et
d'obtenir la limite inférieure et la limite supérieure de la tension de programme, l'obtention comprenant (i) la programmation d'une partie de la mémoire OTP en utilisant initialement une tension de programme basse et en augmentant progressivement par incréments la tension de programme jusqu'à ce que toutes les cellules OTP dans cette partie de la mémoire OTP soient programmées et leurs courants de cellule soient inférieurs à une valeur prédéterminée pour déterminer une limite inférieure de la tension de programme ; et (ii) l'augmentation par incréments de la tension de programme et la programmation de la même partie de la mémoire OTP jusqu'à ce qu'une tension excessive soit identifiée où au moins une cellule OTP programmée a le courant de cellule supérieur à une valeur prédéterminée ou au moins une cellule OTP non programmée a le courant de cellule inférieur à une autre valeur prédéterminée, pour déterminer une limite supérieure de la tension de programme.

14. Procédé de programmation de mémoire OTP (740) selon la revendication 12, dans lequel le procédé comprend le fait de programmer une seule fois une autre cellule OTP de la pluralité de cellules OTP en appliquant une tension entre les limites inférieure et supérieure de la tension de programme en une impulsion.

15. Procédé de programmation selon la revendication 1, dans lequel l'au moins un sélecteur comprend un dispositif MOS qui peut être mis sous tension dans une diode à jonction (30b) ou dans un canal du dispositif MOS pour programmer ou lire les cellules OTP.

16. Procédé de programmation de mémoire (740) programmable une seule fois, OTP, selon la revendication 1, comprenant le fait :
de programmer au moins une première partie de la mémoire OTP en utilisant initialement une tension de programme basse et en augmentant progressivement par incréments la tension de programme jusqu'à ce que toutes les cellules OTP dans la première partie de la mémoire OTP soient programmées et vérifiées correctement, de manière à déterminer une limite inférieure de la tension de programme ;
d'augmenter par incréments la tension de programme et de programmer ensuite la première partie ou une deuxième partie de la mémoire OTP jusqu'à ce qu'une tension excessive soit identifiée où au moins une cellule OTP, programmée ou non, est vérifiée avec une erreur, de manière à déterminer une limite supérieure de la tension de programme ; et
d'enregistrer les limites inférieure et supérieure de la tension de programme pour une utilisation ultérieure dans la programmation d'une troisième partie de la mémoire OTP ou d'une autre mémoire OTP, en utilisant une tension entre les limites inférieure et supérieure en une seule impulsion.

17. Procédé de programmation selon la revendication 16, dans lequel le procédé comprend le fait :
de programmer ultérieurement la troisième partie de la mémoire OTP en appliquant la tension entre les limites inférieure et supérieure de la tension de programme en une seule impulsion à au moins une cellule OTP dans la mémoire OTP.

18. Procédé de programmation selon la revendication 16, dans lequel le procédé comprend le fait :
de programmer ultérieurement au moins une partie de l'autre mémoire OTP en appliquant la tension entre les limites inférieure et supérieure de la tension de programme en une seule impulsion à au moins une cellule OTP dans l'autre mémoire OTP.

19. Mémoire (740) programmable une seule fois, OTP, comprenant :
une pluralité de cellules OTP (742), chacune des cellules OTP (30) comportant au moins :
un élément OTP (30a) comportant au moins un fusible électrique couplé à une première ligne de tension d'alimentation ; et
un sélecteur (30b) couplé à l'élément OTP et à une deuxième ligne de tension d'alimentation,
dans laquelle la mémoire OTP (740) est configurée pour programmer une première cellule des cellules OTP en appliquant une pluralité d'impulsions de tension ou de courant aux première et deuxième lignes de tension d'alimentation pour mettre sous tension le sélecteur et pour changer ainsi une résistance de fusible progressivement et ainsi établir une tension supérieure et une tension inférieure, et
dans laquelle la mémoire OTP (740) est en outre configurée pour programmer une deuxième cellule des cellules OTP en une impulsion en appliquant une tension de programme entre les niveaux de tension inférieur et supérieur.
